# EUROPEAN PATENT APPLICATION

(11) **EP 4 531 072 A1**
(43) Date of publication of application: **02.04.2025**
(21) Application number: 23200316.0
(22) Date of filing: 28.09.2023
(51) Int. Cl.: H01J 37/21, H01J 37/22, H01J 37/28

(54) **METHOD OF ASSESSING A CHARGED PARTICLE BEAM, AND METHOD OF ASSESSING A BEAM GRID**

(71) Applicant: ASML Netherlands B.V., 5500 AH Veldhoven (NL)
(72) Inventor: POSTMES, Isabella, Leoni, 5500 AH Veldhoven (NL); DE VRIES, Hendrik, Wessel, 5500 AH Velhhoven (NL); STEUNEBRINK, Martin, 5500 AH Veldhoven (NL); KIERS, Antoine, Gaston, Marie, 5500 AH Veldhoven (NL); FLIERVOET, Timotheus, Fransiscus, 5500 AH Veldhoven (NL)
(74) Representative: ASML Netherlands B.V.

(57) **Abstract**

Methods and apparatus for assessing a charged particle beam are disclosed. In one arrangement, a plurality of images of a reference pattern on a sample is generated by scanning a charged particle beam over the reference pattern at each of a corresponding plurality of focus conditions and detecting signal charged particles emitted from the sample. At least an astigmatism characteristic of the beam is determined by analyzing the images.

## Description

### FIELD

The present disclosure relates to methods of assessing one or more charged particle beams. The disclosure is particularly applicable where the beams are provided as a beam grid and/or where the beams are used by an assessment apparatus to assess an object using the beams.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the assessment for example inspection and/or measurement of a surface of a substrate, or other object/material, is an important process during and/or after its manufacture.

Assessment tools, which may be referred to as assessment apparatuses or assessment systems, are known that use a charged particle beam to assess objects, which may be referred to as samples, for example to detect pattern defects. These systems typically use electron microscopy techniques, such as a scanning electron microscope (SEM). In a SEM, a primary electron beam of electrons at a relatively high energy is targeted with a final deceleration step to land on a sample at a relatively low landing energy. The beam of electrons is focused as a probing spot on the sample. The interactions between the material structure at the probing spot and the landing electrons from the beam of electrons cause signal electrons to be emitted from the surface, such as secondary electrons, backscattered electrons or Auger electrons. The signal electrons may be emitted from the material structure of the sample. By scanning the primary electron beam as the probing spot over the sample surface, signal electrons can be emitted across the surface of the sample. By collecting these emitted signal electrons from the sample surface it is possible to obtain an image representing characteristics of the material structure of the surface of the sample.

Performance of assessment apparatuses may be limited by imperfections in charged particle beams as they impinge on samples. Such imperfections may include defocus and astigmatism. It is desirable to minimize such imperfections. Iterative schemes may be used to reduce such imperfections. Such schemes may iteratively change beam settings of a beam while monitoring a spatial resolution achieved by the beam until the spatial resolution of the beam reaches a lowest achievable value for the beam. Such schemes can be complex and time-consuming, particularly for multi-beam systems having a large number of beams.

### SUMMARY

It is an object of the disclosure to provide methods of assessing a charged particle beam that support improved performance of an assessment apparatus.

According to an aspect of the invention, there is provided a method of assessing a charged particle beam, comprising: generating a plurality of images of a reference pattern on a sample by scanning a charged particle beam over the reference pattern at each of a corresponding plurality of focus conditions and detecting signal charged particles emitted from the sample; and determining at least an astigmatism characteristic of the beam by analyzing the images.

According to an aspect of the invention, there is provided an assessment apparatus, comprising: a charged particle-optical system configured to project a charged particle beam towards a sample comprising a reference pattern; a detector configured to detect signal charged particles emitted from the sample; and a controller configured to: control at least the charged particle-optical system to scan the charged particle beam over the reference pattern of the sample at a plurality of focus conditions; receive a detection signal from the detector, the detection signal representing signal charged particles emitted from the sample at the different focus conditions; generate from the detection signal a plurality of images of the reference pattern corresponding to the plurality of focus conditions; and determining at least an astigmatism characteristic of the beam by analyzing the images.

According to an aspect of the invention, there is provided an assessment apparatus, comprising: a charged particle-optical system configured to project a beam grid comprising a plurality of charged particle beams towards a sample having reference patterns; a detector configured to detect signal charged particles emitted from the sample; and a controller configured to: control at least the charged particle-optical system to scan each of two or more beams of the beam grid over a reference pattern of the sample corresponding to the beam at a plurality of focus conditions; receive a detection signal from the detector, the detection signal representing signal charged particles emitted from the sample at the different focus conditions; generate from the detection signal a plurality of images of the reference pattern corresponding to the plurality of focus conditions for each of the two or more beams; and determining at least an astigmatism characteristic of the beam by analyzing the images.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary charged particle beam inspection apparatus.
**FIG. 2** is a schematic diagram illustrating an exemplary multi-beam apparatus that is part of the exemplary charged particle beam inspection apparatus of **FIG. 1****.**
**FIG. 3** is a schematic diagram of an exemplary electron-optical device comprising a condenser lens array, an objective lens array and a detector array.
**FIG. 4** is a schematic cross-sectional view of a portion of an objective lens array and detector array of an exemplary arrangement.
**FIG. 5** is bottom view of the portion of the detector array of **FIG. 4****.**
**FIG. 6** is a schematic diagram of an exemplary electron-optical device comprising an objective lens array and a beam separator.
**FIG. 7** is a diagram of a further exemplary electron-optical device.
**FIG. 8** is a schematic side view of a portion of an electron-optical device adjacent to a sample to depict astigmatism and defocus for different beams of a beam grid.
**FIG. 9** schematically depicts: (left) variation along Z of a beam waist of beams shown in **FIG. 8****;** and (right) variations in the shape of a beam spot for different sample positions and different beams of the beam grid.
**FIG. 10** is a flow chart depicting a method of assessing a charged particle beam.
**FIG. 11** schematically depicts images of a reference pattern obtained at different focus conditions (left) and two corresponding pluralities of sets of values (top right and bottom right) representing distributions of directional sharpness data corresponding to two different respective directions.
**FIG. 12** schematically depicts an elongate region containing points in a scatterplot of directional sharpness data relative to horizontal and vertical axes representing different directions of the directional sharpness data.
**FIG. 13** schematically depicts sub-regions containing retained points in the scatterplot of **FIG. 12** after a filtering operation.
**FIG. 14** is a graph showing example application of a step of using directional sharpness data to identify focus conditions at which variances of the directional sharpness along axes of astigmatism are maximal by obtaining maxima of eigenvalues of a covariance matrix as a function of focus condition.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000^{th} of a human hair. Thus, it is not surprising that semiconductor IC manufacturing is a complex and time-consuming process, with hundreds of individual steps. Errors in even one step have the potential to dramatically affect the functioning of the final product. Even a single defect can cause device failure in certain situations. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection systems (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical device or column. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be more generally be considered to be references to charged particles, with the charged particles not necessarily being electrons.

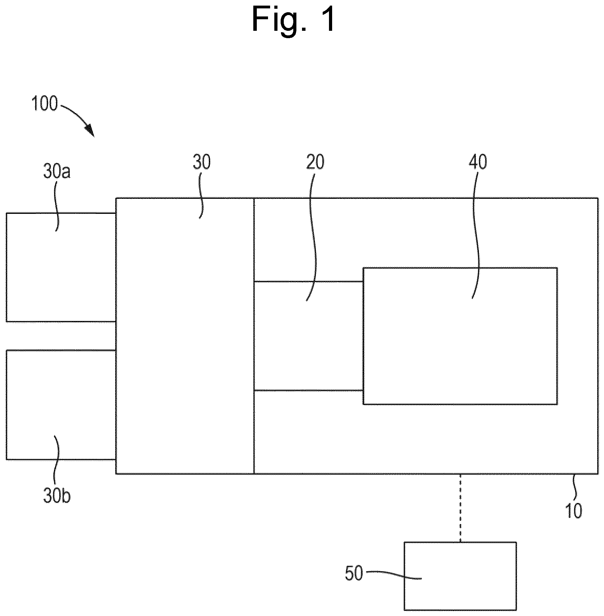

Reference is now made to **FIG. 1****,** which is a schematic diagram illustrating an exemplary charged particle beam inspection apparatus 100, which may also be referred to as a charged particle beam assessment system or simply assessment system. The charged particle beam inspection apparatus 100 of **FIG. 1** includes a main chamber 10, a load lock chamber 20, an electron beam apparatus 40, an equipment front end module (EFEM) 30 and a controller 50. The controller may be distributed between different components of the assessment system, including for example in the electron beam apparatus 40. Electron beam apparatus 40 is located within main chamber 10.

EFEM 30 includes a first loading port 30a and a second loading port 30b. EFEM 30 may include additional loading port(s). First loading port 30a and second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in EFEM 30 transport the samples to load lock chamber 20.

Load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from load lock chamber 20 to main chamber 10. Main chamber 10 is connected to a main chamber vacuum pump system (not shown). The main chamber vacuum pump system removes gas particles in main chamber 10 so that the pressure in around the sample reaches a second pressure lower than the first pressure. After reaching the second pressure, the sample is transported to the electron beam apparatus by which it may be inspected. An electron beam apparatus 40 may comprise a multi-beam electron-optical apparatus.

Controller 50 is signally, for example electronically, connected to electron beam apparatus 40, for example as distributed components of the controller 50. Controller 50 may be a processor (such as a computer) configured to control the charged particle beam inspection apparatus 100. Controller 50 may also include a processing circuitry configured to execute various signal and image processing functions. While controller 50 is shown in **FIG. 1** as being outside of the structure that includes main chamber 10, load lock chamber 20, and EFEM 30, it is appreciated that controller 50 may be part of the structure. The controller 50 may be located in one of the component elements of the charged particle beam inspection apparatus or it can be distributed over at least two of the component elements. While the present disclosure provides examples of main chamber 10 housing an electron beam inspection apparatus, it should be noted that aspects of the disclosure in their broadest sense are not limited to a chamber housing an electron beam inspection apparatus. Rather, it is appreciated that the foregoing principles may also be applied to other systems and other arrangements of apparatus, that operate under the second pressure.

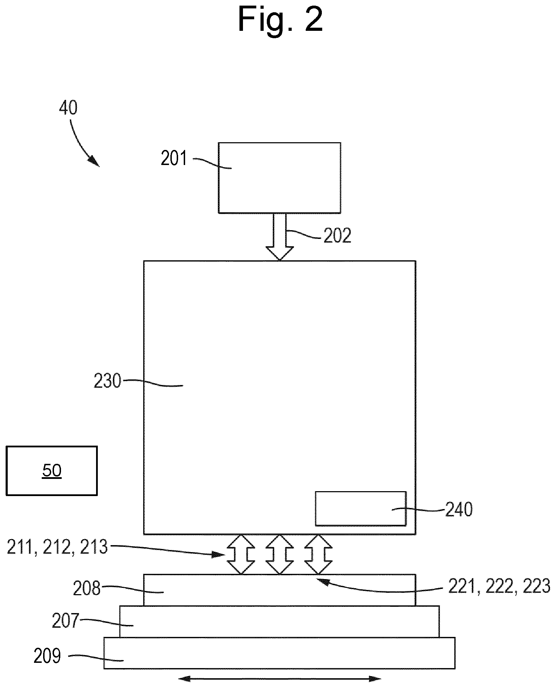

Reference is now made to **FIG. 2****,** which is a schematic diagram illustrating an exemplary electron beam apparatus 40. The electron beam apparatus 40 may be provided as part of the exemplary charged particle beam inspection system 100 of **FIG. 1****.** The electron beam apparatus 40 includes an electron source 201 and a charged particle column (or device) 230. The charged particle device 230 may be referred to or comprise a projection apparatus for directing a primary charged particle beam 202 towards a sample 208. The electron source 201 and associated and component charged particle optical elements may be referred to as an illumination apparatus for generating a primary charged particle beam 202. The apparatus comprises a sample support that supports a sample 208. The sample support in this example comprises a sample holder 207. The sample holder 207 holds the sample 208 (e.g., a substrate or a mask) for assessment. The sample holder 207 is supported by a motorized or actuated stage 209. The electron beam apparatus 40 further comprises a detector 240. The detector 240 detects signal charged particles (e.g., electrons) from the sample 208. The detector 240 generates detection signals on detection of the signal charged particles.

The electron source 201 may comprise a cathode (not shown) and an extractor or anode (not shown). During operation, electron source 201 is configured to emit electrons as primary electrons from the cathode. The primary electrons are extracted or accelerated by the extractor and/or the anode to form the primary electron beam 202.

The charged particle device 230 is configured to convert primary electron beam 202 into a plurality of charged particle beams 211, 212, 213 and to direct each beam onto the sample 208. Although three beams are illustrated for simplicity, there may be many tens, many hundreds, many thousands, many tens of thousands, or even hundreds of thousands (or more) of beams. The beams may be referred to as beamlets or sub-beams. The plurality of charged particle beams may be referred to collectively as a multi-beam or beam grid. A beam grid with so many beams (e.g. more than a thousand beams) may have a field of view of e.g. more than 0.5mm, for example in the range of 0.5 to 30mm or 1 to 30 mm, for example in the range of 0.5 to 15mm.

The controller 50 (for example control system comprising distributed controllers) may be connected to various parts of charged particle beam inspection apparatus 100 of **FIG. 1****,** such as the electron source 201, the electron detection device 240, the charged particle device 230, and actuated stage 209. The controller 50 may perform various image and signal processing functions. The controller 50 may also generate various control signals to govern operations of the charged particle beam inspection apparatus 100, including operations of the electron beam apparatus 40.

The charged particle device 230 may be configured to focus, for example, beams 211, 212, and 213 onto a sample 208 for inspection and may form three probe spots 221, 222, and 223 on the surface of sample 208. The charged particle device 230 may be configured to deflect primary beams 211, 212, and 213 to scan probe spots 221, 222, and 223 across individual scanning areas in a section of the surface of sample 208. In response to incidence of primary beams 211, 212, and 213 on probe spots 221, 222, and 223 on sample 208, electrons are generated from the sample 208 which include secondary electrons and backscattered electrons which may be referred to as signal charged particles. The secondary electrons typically have electron energy as large as fifty electron volts (≤ 50 eV) and backscattered electrons typically have electron energy between fifty electron volts (50 eV) and the landing energy of primary beams 211, 212, and 213.

The detector 240 may send the detection signals generated in the detector 240, for example as an imaging or detection signal, to the controller 50 or a signal processing system (not shown which may be part of the controller 50), e.g. to construct images of the corresponding scanned areas of sample 208. The detector 240 may be incorporated at least partly into the charged particle device 230 or may be separate therefrom, for example where a secondary optical column directs secondary electrons to the detector 240.

The controller 50 may comprise an image processing system that includes an image acquirer (not shown) and a storage device (not shown). For example, the controller may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive the detection signal from the detector 240, may process the data comprised in the signal and may construct an image therefrom. The image acquirer may thus acquire images of sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The image acquirer may acquire one or more images of a sample 208 based on an imaging signal received from the detector 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of the detected secondary electrons. A part of the controller for such a function may be comprised in or proximate to the detector. The electron distribution data, collected during a detection time window, can be used in combination with corresponding scan path data of each of primary beams 211, 212, and 213 incident on the sample surface to reconstruct images of the sample structures under inspection. The reconstructed images can be used to reveal various features of the internal or external structures of sample 208. The reconstructed images can thereby be used to reveal any defects that may exist in and/or on, thus of the sample.

The controller 50 may control actuated stage 209 to move sample 208 during inspection of sample 208, for example to provide a scanning motion of the stage relative to the paths of the primary beams. The controller 50 may enable actuated stage 209 to move sample 208 in a direction such as part of the scanning motion of the stage, preferably continuously, for example at a constant speed, at least during sample inspection. The controller 50 may control movement of the actuated stage 209 so that it changes the speed of the movement of the sample 208 dependent on various parameters. For example, the controller may control the stage speed (including its direction) depending on the characteristics of the inspection steps and/or scans of the scanning process for example as disclosed in EP 4 086 933 A1 which is hereby incorporated by reference in so far as the combined stepping and scanning strategy at least of the stage. In controlling the actuated stage, actuation of the stage and thus the sample may enable the sample to be positioned, for example dynamically, relative to the paths of the primary beams.

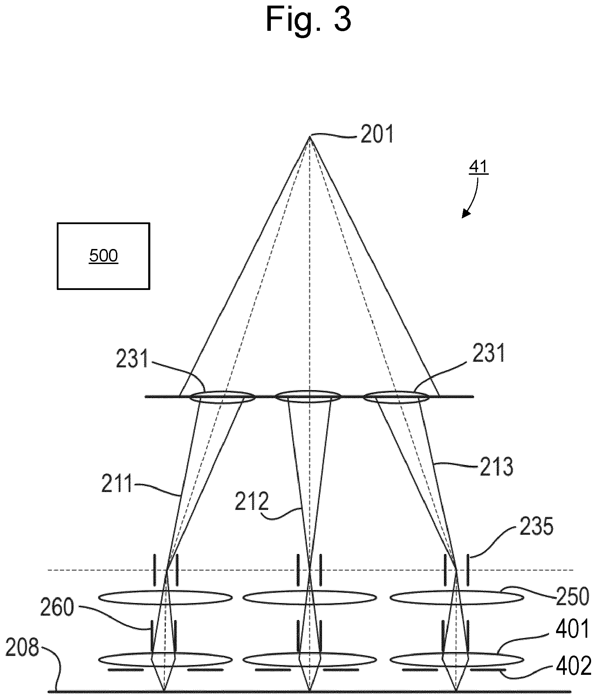

**FIG. 3** is a schematic diagram of an exemplary electron-optical device 41 (which may also be referred to as a charged particle device) for use in an assessment apparatus. For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of electron-optical devices such as those discussed herein, it will be understood that lens arrays will typically operate electrostatically and so may not require any physical elements adopting a biconvex shape. As described below, lens arrays may instead comprise multiple plates with apertures. Each plate with apertures may be referred to as an electrode. The electrodes may be provided in series along a path of a beam grid of a plurality of charged particle beams (which may also be referred to as sub-beams). The electrodes are thus also in series along paths of charged particle beams of the beam grid.

Electron source 201 directs electrons toward an array of condenser lenses 231 forming part of electron-optical device 41. The electron source 201 is desirably a high brightness thermal field emitter with a good compromise between brightness and total emission current. There may be many tens, many hundreds or many thousands or even tens of thousands of condenser lenses 231. Condenser lenses of array 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The condenser lens array may take the form of at least two, preferably three, plates, acting as electrodes, with apertures in each plate aligned with apertures in other plates to define paths for charged particle beams through the plates. At least two of the plates are maintained during operation at different potentials to achieve the desired lensing effect. Between the plates of the condenser lens array are electrically insulating plates, for example made of an insulating material such as a ceramic (e.g., quartz) or glass, with one or more apertures for the charged particle beams. Additionally or alternatively, one or more of the plates may feature apertures that each have their own electrode, for example with an array of electrodes around their perimeter or arranged in groups of apertures having a common electrode. In a variant, one or more of the plates may comprise multiple portions or strips with multiple apertures. In a further alternative arrangement, a macro collimator is provided instead of the condenser lens array. The macro collimator may act on the beam from the source 201 before the beam has been split into a multi-beam. The macro collimator may be implemented magnetically, electrostatically, or magnetically and electrostatically.

In some embodiments, the condenser lens array is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

Each condenser lens in the array directs electrons into a respective beam 211, 212, 213 which is focused at a respective intermediate focus 233. A collimator or an array of collimators may be positioned to operate on the respective intermediate focuses 233. The collimators may take the form of deflectors 235 provided at the intermediate focuses 233. Deflectors 235 are configured to bend a respective beam 211, 212, 213 by an amount effective to ensure that the principal ray (which may also be referred to as the beam axis) is incident on the sample 208 substantially normally (i.e. at substantially 90° to the nominal surface of the sample). Note that in an arrangement with a macro condenser lens, the condenser lens may collimate or contribute to the collimation of the source beam or, in an embodiment, a plurality of beams.

An objective lens array 401 is provided down-beam from the deflectors 235. The objective lens array 401 comprises an objective lens for each beam 211, 212, 213. The objective lens array 401 projects the beams 211, 212, 213 onto the sample 208. The objective lens array 401 may comprise two or more, preferably at least three, plate electrode arrays connected to respective potential sources.

Optionally, a control lens array 250 is provided between the deflectors 235 and the objective lens array 401. The control lens array 250 comprises a control lens for each beam 211, 212, 213. The control lens array 250 provides additional degrees of freedom for controlling properties of the beams 211, 212, 213. The control lens array 250 may comprise two or more, preferably at least three, plate electrode arrays connected to respective potential sources. A function of control lens array 250 is to optimize the beam opening angle with respect to the demagnification of the beam and/or to control the beam energy delivered to the objective lenses, each of which directs a respective beam 211, 212, 213 onto the sample 208. In an embodiment the control lens array may be considered to be part of the objective lens, for example in being additional plates associated with the objective lens array.

Optionally an array of scan deflectors 260 is provided between the control lens array 250 and the objective lens array 401. The array of scan deflectors 260 comprises a scan deflector for each beam 211, 212, 213. Each scan deflector is configured to deflect a respective beam 211, 212, 213 in one or two directions to scan the beam across the sample 208 in one or two directions. Alternatively, a macro scan deflector may be provided to scan the charged particle beams over the sample 208. The macro scan deflector may be provided up-beam of the control lens array 250. In an embodiment such a macro scan deflector may operate on the source beam and may be present with a macro condenser lens.

A detector module 402 of a detector is provided within the objective lenses or between the objective lenses and the sample 208 to detect signal electrons/particles from the sample 208. An exemplary construction of such a detector module 402 is described below. Note that the detector additionally or alternatively may have detector elements up-beam along the primary beam path of the objective lens array 401 or even the control lens array 250. The detector module may be an array of detector elements (e.g. a detector array). Each element may be associated with an individual beam, for example positioned to detect signal particles generated by the individual beam. The detector module may comprise at least one of scintillator elements, semiconducting elements or charge capture electrodes, for example to capture signal electrons as current.

The electron-optical device 41 of **FIG. 3** may be configured to control the landing energy of electrons on the sample 208 by varying potentials applied to the electrodes of the control lenses and the objective lenses. The electrodes may comprise plates and be referred to as plates or electron-optical plates. The control lenses and objective lenses work together and may be referred to as an objective lens assembly. The landing energy can be selected to increase emission and detection of secondary electrons dependent on the nature of the sample being assessed. The detector module may be comprised in the objective lens assembly.

The objective lenses can be configured to demagnify the electron beam by a factor greater than 10, desirably in the range of 50 to 100 or more. The objective lenses may comprise three electrodes: a middle electrode, a lower electrode and an upper electrode. The upper electrode may be omitted. An objective lens having only two electrodes can have lower aberration than an objective lens having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beams.

In some embodiments, the objective lens array assembly comprises a detector having a detector module 402 down-beam of at least one electrode of the objective lens array 401. The detector module 402 may comprise or even take the form of a detector array. In an embodiment, at least a portion of the detector is adjacent to and/or integrated with the objective lens array 401. For example, the detector module 402 may be implemented by integrating a CMOS chip detector into a bottom electrode of the objective lens array 401. Integration of a detector module 402 into the objective lens array may replace a secondary column. The CMOS chip is preferably orientated to face the sample (because of the small distance between sample and the bottom of the electron-optical system, which may for example be in the range of 10 to 400 micron, desirably in the range of 50 to 200 micron, optionally about 100 micron). It is noted that even in situations in which the detector is up-beam of the most down-beam electron-optical element of the charged particle device, there may be a close, e.g. of similar distance, separation between the most down-beam electron-optical element and the sample (e.g. about 100 micron). In an embodiment, electrodes to capture the signal charged particles are formed in the top metal layer of the CMOS device. The electrodes can be formed in other layers of the substrate, e.g. of the CMOS chip. Power and control signals of the CMOS may be connected to the CMOS by through-silicon vias. For robustness, preferably the bottom electrode consists of two elements: the CMOS chip and a passive Si plate with holes. The plate shields the CMOS from high E-fields.

In an embodiment, a single electrode surrounds at least some of the apertures. In an arrangement a single electrode is assigned for example around each aperture. In another embodiment, a plurality of electrode elements are provided around each aperture for example as a detector element. The signal charged particles captured by the electrode elements surrounding one aperture may be combined into a single detection signal or used to generate independent detection signals. The electrode elements may be divided radially (i.e., to form a plurality of concentric annuluses), angularly (i.e., to form a plurality of sector-like pieces), both radially and angularly (providing an arrangement like a dart board), or in a grid (for example as a chess board) or in any other convenient manner.

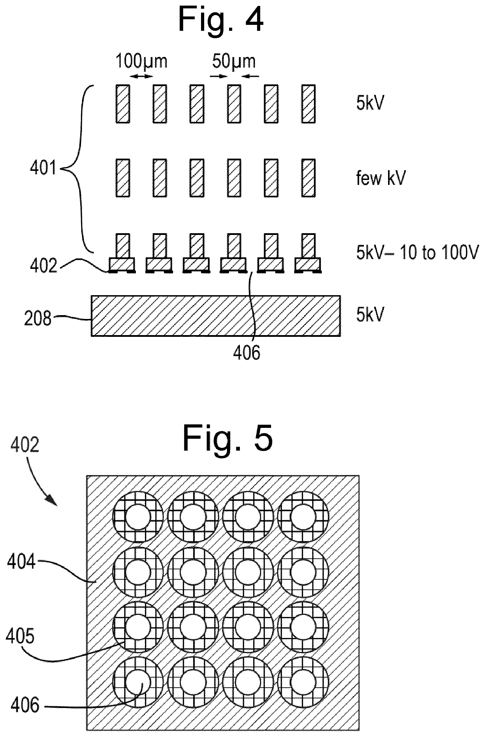

An exemplary embodiment of a detector integrated into an objective lens array 401 is shown in **FIG. 4****,** which illustrates a portion of an objective lens array 401 in schematic cross section. In this embodiment, the detector comprises a detector module 402 comprising a plurality (e.g., an array) of detector elements 405, shown in **FIG. 5** (e.g., sensor elements such as capture electrodes), preferably as an array of detector elements (i.e. a plurality of detector elements in a pattern or arrangement preferably over a two dimensional surface). In this embodiment, the detector module 402 is provided on an output side of the objective lens array. The output side is the output side of the objective lens array 401. **FIG. 5** is a bottom view of detector module 402 which comprises a substrate 404 on which are provided a plurality of detector elements (or capture electrodes 405) each surrounding a beam aperture 406. The beam apertures 406 may be formed by etching through substrate 404. In the arrangement shown in **FIG. 5****,** the beam apertures 406 are shown in a rectangular array. The beam apertures 406 can also be differently arranged, e.g. in a hexagonal close packed array.

The integrated detector module 402 described above is particularly advantageous when used with an assessment apparatus (e.g. comprising an electron-optical device) having tunable landing energy because secondary electron capture can be optimized for a range of landing energies. A detector module having or in the form of an array can also be integrated into other electrode arrays, not only the lowest electrode array. Further details and alternative arrangements of a detector module integrated into an objective lens can be found in EP 3 937 204 A1, which document is hereby incorporated by reference.

An electric power source may be provided to apply respective potentials to electrodes of the control lenses of, for example, the control lens array 250 and the objective lenses of the objective lens array 401 and the condenser lenses of the condenser lens array or any electron-optical element or component of the electron-optical device 41 for example the detector module (such as when integrated into the objective lens array or when the objective lens and detector module are separate components). A controller 50 may control the potentials applied to the electron-optical components such as the electrodes of the condenser lens array, objective lens array and/or control lens array.

The electron-optical device 41 may comprise other electron-optical components such as charged particle correctors, for example as corrector arrays for alignment of the source to the sample and between beams of the multi-beam and for adjusting the focus of different groups of the beam grid, or individual beams of the beam grid. Such correctors may be controlled to operate dynamically and/or statically, for example during step-up, servicing or during calibration of the electron-optical device 41.

In an embodiment, an array of electron-optical devices (or device array) is provided. The array may comprise a plurality of any of the electron-optical devices (e.g., electron-optical columns or charged particle devices) described herein. Each of the electron-optical devices in the array focuses respective pluralities of charged particle beams onto different regions of the same sample 208. Each electron-optical device in the array may derive a respective plurality of charged particle beams from a different respective source 201. Each respective source 201 may be one source in a plurality of sources 201. At least a subset of the plurality of sources 201 may be provided as a source array. The source array may comprise a plurality of emitters on a common substrate. The focusing of pluralities of charged particle beams from different electron-optical devices simultaneously onto different regions of the same sample allows an increased area of the sample 208 to be exposed to charged particle beams simultaneously. Therefore, an increased area of the sample may be processed (e.g. assessed) at one time. The electron-optical devices in the device array may be arranged adjacent to each other so as to project the respective pluralities of beams onto adjacent regions of the sample 208. Any number of electron-optical devices may be used in the array. Preferably, the number of electron-optical devices is in the range of 9 to 200. Each electron-optical device in the device array may be configured in any of the ways described herein when referring to a single electron-optical device, charged particle device or system or column. Alternatively or additionally, one or more of the electron-optical devices in the array may be configured to project a single beam.

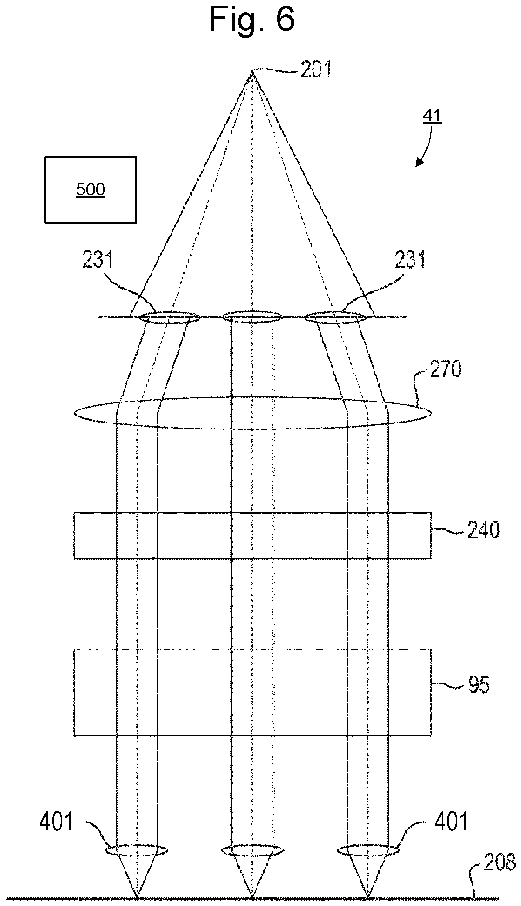

**FIG. 6** schematically depicts a further example of an electron-optical device 41. Features that are the same as those described above are given the same reference numerals. For conciseness, such features are not described in detail with reference to **FIG. 6****.** For example, the source 201, the condenser lenses 231, the objective lens array 401 and the sample 208 (e.g., on a sample support 207) may be as described above. In this example, a macro collimator 270 is provided instead of a deflector array of the type described above with reference to **FIG. 3****.** Such a macro collimator may be a macro lens that may be magnetic, electrostatic or both. In other embodiments, a deflector array may be used to at least contribute to the collimation of the beams, so the deflector array is for finer deflection towards collimation than the action of the macro collimator 270. Such an arrangement may also comprise an array of multiple deflectors (for example in which each aperture has multiple electrodes) for even finer collimation. In an arrangement the condenser lenses 231 may comprise a single plate defining a beam limiting aperture array in which are defined a plurality of apertures with one or more associated macro electrodes with a single aperture. Such a beam limiting aperture array and an associated macro electrode may also form a condenser lens array to focus the generated beams in an intermediate focus which desirably corresponds to the position of the collimator 270.

As described above, in some embodiments a detector may be provided between the objective lens array 401 and the sample 208. The detector may face the sample 208. Alternatively, as shown in **FIG. 6****,** the detector 240 may be implemented such that the objective lens array 401 is between the detector 240 and the sample 208.

In an embodiment a deflector array 95 is provided between the detector 240 and the objective lens array 401. In an embodiment the deflector array 95 comprises a Wien filter array so that deflector array 95 may be referred to as a beam separator. The deflector array 95 is configured to provide a magnetic field and an electrostatic field. The electrostatic and magnetic fields operate together to separate the charged particles projected to the sample 208 relative to the signal particles e.g. electrons from the sample 208. The operation of the fields directs the signal particles towards the detector 240.

In an embodiment the detector 240 is configured to detect signal particles by reference to the energy of the charged particle, i.e. dependent on a band gap, such a semiconductor based type of detector. Such a detector 240 may be called an indirect current detector. The secondary electrons emitted from the sample 208 gain energy from the fields between the electrodes. The secondary electrons have sufficient energy once they reach the detector 240. In a different arrangement the detector 240 may be an electron to photon converter such as a scintillator array, for example of fluorescing strip between the beams that are positioned up beam along the primary beam path with respect to the Wien filter. Primary beams passing through the Wien filter array (of magnetic and electrostatic strips orthogonal to the primary beam path) have paths upbeam and downbeam of the Wien filter array that are substantially parallel, whereas signal electrons from the sample are directed by the Wien filter array towards the scintillator array. The electron to photon converter may be photonically coupled to a photon to electron converter to convert any photons generated in and emitted by the electron to photon converter. The photon to electron converter may be electrically connected to electronic circuitry to process a detection signal. In different embodiments the photon to electron converter may be within or external to the charged particle device. In an embodiment photon coupling may be by via a photon transport unit (e.g., an array of optical fibers) to a remote optical detector which generates a detection signal on detection of a photon.

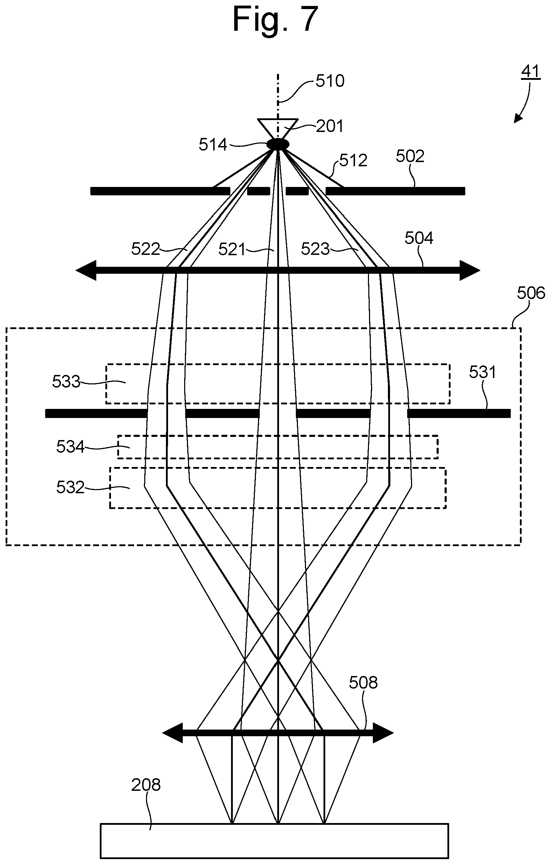

**FIG. 7** is a schematic diagram of a further exemplary electron-optical device 41 for use in an assessment apparatus. The electron-optical device 41 may be used in combination with any of the embodiments described herein, for example instead of any of the electron-optical devices 41 described above, such as with reference to **FIG.** 3 and/or **FIG. 6****.** In this example, the electron-optical device 41 comprises an electron source 201, a beam-forming aperture array 502, a condenser lens 504, a source conversion unit 506, an objective lens 508, and a sample 208. The source 201 and the sample 208 may take any of the forms described above with reference for example to **FIG. 2****,** **3** and **6** for example. The source 201, beam-forming aperture array 502, condenser lens 504, source conversion unit 506, and objective lens 508 may be aligned with a primary electron-optical axis 510 of the charged particle device 41. The source 201 generates a primary electron beam 512 with a source cross-over 514. The beam-forming aperture array 502 forms beams 521, 522, 523 from the primary beam 512. A line of three beams is depicted but the beam-forming aperture array 502 may be configured to form a line of two beams or a line of more than three beams, such as a line of four beams or a line of five beams. The beam-forming aperture array 502 may also be configured to form multiple lines of beams, thereby forming an array of beams. For example, the beam-forming aperture array 502 may be configured to form an n × m array of beams where *n* and *m* are integers that may be the same or different, such as a 3 × 3 array of beams, a 4 × 4 array of beams, or a 5 × 5 array of beams.

The condenser lens 504 may be configured to re-direct paths of the beams 521, 522, 523 to be substantially parallel to each other and/or to be incident substantially perpendicularly onto the source conversion unit 506. The condenser lens 504 may be a macro magnetic lens arrangement such as a multiple, e.g. two, lenses set at a non-rotational setting (by which the rotational effect of the different lenses of the lens arrangement cancel or their net rotational effect on the paths of the beams is substantially zero).

The source conversion unit 506 may include a beam-limiting aperture array 531 defining apertures configured to laterally limit each of the beams 521, 522, 523. The beam-limiting aperture array 531 may shape one more of the beams 521, 522, 523 for example to separate the beams into two or more beams down beam of the beam-limiting aperture array 531 for example towards a sample.

The source conversion unit 506 may comprise an array of electron-optical components for operating on each beam or a group of beams of the plurality of beams. The source conversion unit 506 may include an image-forming element array 532 comprising an array of micro-deflectors configured to deflect the beams 521, 522, 523 towards the axis 510. The deflected beams 521, 522, 523 may form virtual images of the source crossover 514 on the sample 208.

The source conversion unit 506 may include an aberration compensator array 534 configured to compensate aberrations in the beams 521, 522, 523. The aberration compensator array 534 may be configured to compensate for field curvature and/or astigmatism for example.

The source conversion unit 506 may include a pre-bending micro-deflector array 533 configured to bend paths of the beams 521, 522, 523 upbeam of the beam-limiting aperture array 531, for example to cause paths of the beams 521, 522, 523 to be incident substantially perpendicularly onto the beam-limiting aperture array 531.

The image-forming element array 532, the aberration compensator array 534, and/or the pre-bending micro-deflector array 533 may comprise multiple layers of sub-beam manipulating devices, some of which may be in the form of arrays, for example: micro-deflectors, micro-lenses, and/or micro-stigmators.

In the example shown, the objective lens 508 comprises a magnetic lens that acts macroscopically on the beams to focus the beams onto the sample 208. In other embodiments, the objective lens 508 may comprise an objective lens array implemented electrostatically, or a combination of magnetic and electrostatic lenses may be used; for example a macro magnetic objective lens with electrostatic elements.

As described above, electron-optical elements such as plates 60 may be configured to act as electrodes, for example as part of an objective lens array. Geometric features of the plates 60 allow charged particle beams to pass through the plates 60. Such features are: channels through the plates 60 and apertures defined in surfaces of the plates. An aperture may be defined by respective channel opening in a surface. A channel (which may be referred to as a through-hole) may connect different apertures in opposing surfaces of a plate. Electric fields adjacent to apertures associated with the channels may apply a lensing effect to the charged particles. In some arrangements, the apertures may be adapted to compensate for aberrations, for example for off-axis aberrations in a multi-beam such as distortion, focus curvature, astigmatism and coma. For example, the apertures of one or more of the electrodes may be shaped, sized and/or positioned to compensate for off-axis aberrations. The apertures may, for example, have a range of different areas (or a range of diameters) to compensate for field curvature, a range of different ellipticities to compensate for astigmatism, and/or a range of different displacements from nominal grid positions to compensate for distortion caused by telecentricity error. See for example WO 2022/101072A1 which is hereby incorporated by reference so far as off-axis aberration correction.

As mentioned in the introductory part of the description, performance of an assessment apparatus for assessing a sample may be limited by imperfections in charged particle beams, such as astigmatism and defocus. As mentioned above, the shapes of apertures of electrodes may be adapted to compensate for astigmatism, for example by defining ellipticities of the apertures that counteract predicted respective astigmatisms of beams corresponding to the apertures. In a multi-beam system, electrodes may comprise a range of different ellipticities and/or orientations of ellipticity to correct for astigmatism aberrations. Such corrections are defined by the physical structure of the electrodes and may be referred to as hard-coded corrections such as disclosed in WO 2022/101072A1 mentioned above. It is desirable to be able to assess astigmatism and defocus that is left over after the hard-coded corrections have been applied. Information about such astigmatism and defocus can be used to calculate improved settings of an electron-optical device 41 for an assessment apparatus. For example, in the case of a multi-beam system a macro focus setting can be calculated that will be expected to obtain a best average focus and/or astigmatism across a beam grid (a plurality of beams, which may be referred to as sub-beams or beamlets, of the multi-beam system).

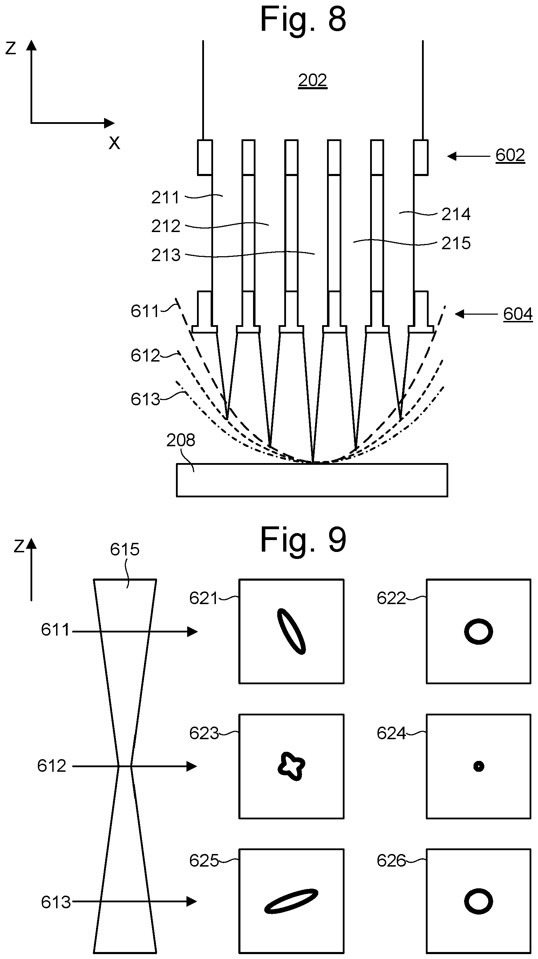

**FIG. 8** and **9** schematically depict astigmatism and defocus for different respective beams 211-215 of a beam grid.

**FIG. 8** schematically depicts splitting of a beam 202 of charged particles (e.g., electrons) by a beam forming array 602 into a representative plurality of beams 211-215. The beams 211-215 are focused onto the sample 208 by an electrode 604 of an objective lens array. Curves 611 and 613 respectively depict variation across the beam grid of a position along a Z axis (a vertical axis in the plane of the page of **FIG. 8****)** at which defocus (or beam waist) in a direction corresponding to a respective component of astigmatism is minimal. (It is noted that astigmatism causes the beam waist to vary differently along the beam for different directions in a cross-section of the beam). Curve 612 depicts variation across the beam grid of a position along the Z axis at which overall defocus is minimal. Curves 611 and 613 thus represent variations in astigmatism across the beam grid and curve 612 represents field curvature.

**FIG. 9** (left) schematically depicts a variation along the direction of the Z axis of a beam waist 615 applicable for any of the beams of the beam grid, with corresponding positions along the direction of the Z axis (or Z positions) of curves 611-613 indicated schematically by arrows labelled 611-613. **FIG. 9** (right) comprises three rows of two boxes (621 and 622; 623 and 624; 625 and 626). These boxes show schematically how the shape of representative beam spots would appear on the sample 208 when the sample 208 is positioned at each of the three positions along the direction of the Z axis (or Z positions) that correspond to the curves 611-613. The three boxes 622, 624, 626 show representative spots from a center beam in the center of the beam grid. The three boxes 621, 623, 625 show representative spots from an off-axis beam at an off-axis position spaced away from the center of the beam grid. Thus, the top row in **FIG. 9** (right), which corresponds to the positions along the direction of the Z axis (or Z positions) corresponding to curve 611, shows that the beam spot for a center beam (box 622) would be relatively circular (indicative of a low astigmatism) and relatively spread out. This is a consequence of a large defocus. The beam spot for an off-axis beam in the top row (box 621) is highly elongate, indicative of a large defocus along a first direction and smaller defocus along a second direction. This is caused by a large astigmatism. The bottom row in **FIG. 9** (right), which corresponds to positions along the direction of the Z axis corresponding to curve 613, shows that the beam spot for the center beam (box 626) would be relatively circular, indicative of a low astigmatism) and relatively spread out. This is a consequence of a large defocus. The beam spot for an off-axis beam in the bottom row (box 625) is highly elongate in a direction perpendicular to the elongation of the beam spot in box 621. The beam spot in box 625 has a large defocus along the second direction and smaller defocus along the first direction. This is caused by the large astigmatism that is present for the off-axis beam corresponding to boxes 621, 623, and 625. The middle row in **FIG. 9** (right), which corresponds to positions along the direction of the Z axis corresponding to curve 612, shows a beam spot for the center beam (box 624) that is relatively circular and small. This is expected as the center beam has low astigmatism and the Z position of curve 612 corresponds to the Z position of best focus. The beam spot for the off-axis beam (box 623) is star-shaped with elongate features extending along the directions of astigmatism. The beam spot is however relatively small overall due to the Z position of curve 612 being the Z position of best focus.

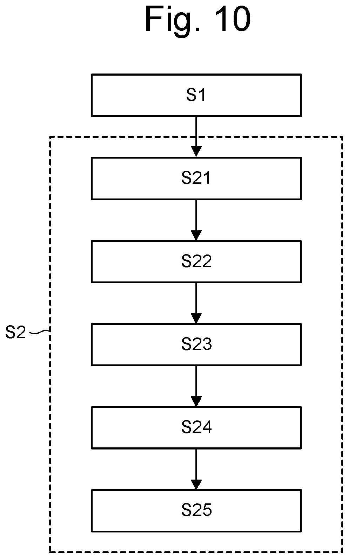

**FIG. 10** depicts the framework of an example method of assessing a charged particle beam, such as any beam of the beam grid. The assessing of the charged particle beam may be referred to as qualifying or calibrating the charged particle beam. The method may be performed by an assessment apparatus, which may be referred to as an assessment system, taking any of the forms described above with reference to **FIG. 1-7****.** The assessment apparatus may comprise a charged particle-optical system configured to project a charged particle beam, optionally a beam grid comprising a plurality of charged particle beams, towards a sample 208. In an embodiment the assessment apparatus comprises a charged particle optical system for projecting a single charged particle beam. The charged particle-optical system may comprise an electron beam apparatus 40 as described with reference to **FIG. 2** and/or an electron-optical device 41 as described with reference to **FIG. 3** to **7****.** The assessment apparatus comprises a detector for detecting signal charged particles emitted from the sample 208. The detector may take any of the forms described above in respect of detector 240, for example with reference to **FIG. 2****.** The detector may comprise a detector module 402, for example in the form of a detector array, as described above with reference to **FIG. 3** to **5****.** The assessment apparatus comprises a controller 50 configured to control the assessment apparatus to perform steps of the method. The controller 50 may take any of the forms described above for the controller 50 and/or otherwise comprise any suitable combination of hardware, firmware, software, power sources, etc. for performing the steps of the method.

The charged particle beam may comprise astigmatism. The astigmatism may comprise two-fold astigmatism, as described above with reference to **FIG. 8** and **9** and/or higher fold astigmatism. The astigmatism of the charged particle beam may be referred to as a characteristic of the charged particle beam, for example an astigmatism characteristic.

In step S1, the method comprises generating a plurality of images of a reference pattern on a sample 208 by scanning a charged particle beam over the reference pattern at each of a plurality of focus conditions.

The controller 50 may thus be configured to control at least the charged particle-optical system to scan the charged particle beam over the reference pattern of the sample at the plurality of focus conditions. The controller 50 may be further configured to receive a detection signal from the detector. The detection signal represents signal charged particles emitted from the sample 208 at the different focus conditions. The controller 50 may be further configured to generate from the detection signal a plurality of images of the reference pattern corresponding to the plurality of focus conditions.

In the case of a multi-beam system, the controller 50 may be configured to control at least the charged particle-optical system to scan each of two or more beams of the beam grid over a reference pattern of the sample corresponding to the beam at a plurality of focus conditions. The controller 50 may be further configured to receive a detection signal from the detector. The detection signal represents signal charged particles emitted from the sample 208 at the different focus conditions. The controller 50 may be further configured to generate from the detection signal a plurality of images of the reference pattern corresponding to the plurality of focus conditions for each of the two or more beams.

The plurality of images may be referred to as a series of images or a sequence of images. Each image is generated by detecting signal charged particles emitted from the sample 208. The plurality of focus conditions may comprise a plurality of positions of a focal plane relative to a portion of a surface of the sample 208 defining the reference pattern. The position of the focal plane relative to the portion of the surface of the sample 208 defining the reference pattern may be varied by changing a Z position (or a position along the direction of the Z axis) and/or tilt of the sample 208, by changing a Z position of the focal plane of the relevant beam, or a combination of both. The Z position and/or tilt of the sample 208 may be adjusted, for example, by moving a sample support in the Z direction and/or by tilting the sample support. Thus, the assessment apparatus may comprise a sample support and the controller 50 may be configured to provide the plurality of focus conditions at least partly by controlling the sample support to vary a position and/or tilt of the sample 208 (e.g., to vary a separation between the sample 208 and the charged particle-optical system). The Z position of the focal plane of the beam may be adjusted, for example, by controlling a lens, such as an objective lens, acting on the beam, for example to change a focusing strength of the objective lens. Thus, the controller 50 may be configured to provide the plurality of focus conditions at least partly by varying a focus setting of the charged particle-optical system. The varying of the focus setting may vary a position of a focal plane of a beam relative to the charged particle-optical system. Defocus will be relatively low when the focal plane is at or close to the portion of the surface of the sample 208 defining the reference pattern. Defocus will increase as the separation between the focal plane and the portion of the surface of the sample 208 defining the reference pattern increases.

In step S2, the method comprises determining at least an astigmatism characteristic of the beam by analyzing the images generated in step S1. The astigmatism characteristic may comprise information about an N-fold astigmatism, where N is equal to or greater than 2. For example, the astigmatism information may comprise information about a two-fold astigmatism, a three-fold astigmatism, a four-fold astigmatism, etc. Higher fold astigmatisms may be assessed most effectively where they are the dominant aberrations remaining (e.g., after other aberrations have been corrected for).

In an embodiment, the analyzing of the images of step S2 comprises a sub-step S21 of determining information about directional sharpness along multiple directions in each image. The number of the directions will typically be determined based on the nature of the astigmatism characteristic that is being assessed. If it is desired to obtain information about an N-fold astigmatism, for example, the number of directions will typically be equal to N. It is possible to use more than N directions but the method will become more complex and computationally costly and the benefits, for example in terms of increased precision, will normally be relatively small. Thus, for example, for assessing a two-fold astigmatism, the number of directions will typically be two, for example perpendicular X and Y directions.

Directional sharpness refers to how accurately the image represents variations in the reference pattern along a particular direction (the direction of the directional sharpness) at a particular location in the image. Directional sharpness may be different for different directions within the image due to astigmatism. For example, if a beam having an elongate beam spot such as that shown in box 621 or 625 of **FIG. 9** were used to obtain an image by scanning the beam spot over a reference pattern, the directional sharpness in a direction corresponding to the direction of elongation of the beam spot would be much lower than the directional sharpness in a direction perpendicular to the direction of elongation of the beam spot. A low directional sharpness along a particular direction would correspond to the image being relatively blurred along that direction. Images of the same reference pattern obtained using the beam spots of boxes 621 and 625 would be blurred along different (perpendicular) directions relative to each other. Various metrics may be used to quantify directional sharpness in an image. In an embodiment, the directional sharpnesses are quantified based on gradients of an image parameter along respective directions. Thus, the determining of information about directional sharpness may comprise determining gradients of an image parameter along the multiple directions. In an embodiment, the image parameter comprises image intensity. In this case, the directional sharpness may be referred to as a directional gradient of signal intensity. Various mathematical operators that provide a measure of sharpness along a direction may be used, such as the Sobel operator, the Prewitt operator, a direct gradient, or a convolution method for edge detection such as a Canny edge detector. Alternatively or additionally, a scale space filter that uses down sampled or blurred versions of an image to express local sharpness (e.g., local phase coherence, wavelet transforms) may be used. In some embodiments, the images may be analyzed in the spatial frequency domain, using transforms such as Fourier transforms or wavelet transforms.

When the directional sharpness is high, the image will respond quickly (in a short distance) to changes in the corresponding reference pattern along the direction of the directional sharpness. For example, if the direction of the directional sharpness passes through an edge of a feature in the reference pattern, the edge will be relatively sharply defined if the directional sharpness is high in comparison to if the directional sharpness is low. A spatial gradient of the intensity will thus be correspondingly high because the intensity will change from a value corresponding to a region outside of the feature to a value corresponding to a region inside the feature over a relatively small number of pixels. Conversely, if the directional sharpness were lower, the same transition in intensity would occur over a larger number of pixels and therefore correspond to a lower spatial gradient.

The method will work with a wide range of reference patterns, including patterns that are not specially designed to be used as reference patterns, such as patterns corresponding to features of devices to be manufactured. The method is thus robust in relation to variations in the reference pattern and does not require a reference pattern to be provided specifically for implementing the method. Preferably, however, the reference pattern comprises features that allow directional sharpness to be assessed in multiple directions, preferably in an unbiased manner. For an n-fold stigmatism characteristic there is a different direction corresponding to each fold of the astigmatism characteristic. The reference pattern may comprise at least one shape having a boundary that is at least partially curved, optionally circular, elliptical or oval. The reference pattern may comprise feature having a range of different sizes. Providing features having a range of sizes may provide features that are suitable for a range of different focus conditions. Reference patterns comprising or consisting of circular features, preferably circular features having a range of sizes, provide particularly good performance. For high sensitivity is it desirable to have a large number of features. Individual features should, however, typically be larger than a diameter of the charged particle beam at the focus condition (e.g., defocus value) at which the astigmatism is most pronounced. For best sensitivity, features should also typically be spaced further apart than a diameter of the charged particle beam at a focus condition corresponding to the largest defocus value used. In some embodiments, the reference pattern is formed by a plurality of spherical objects such as spherical metallic (e.g., gold) balls.

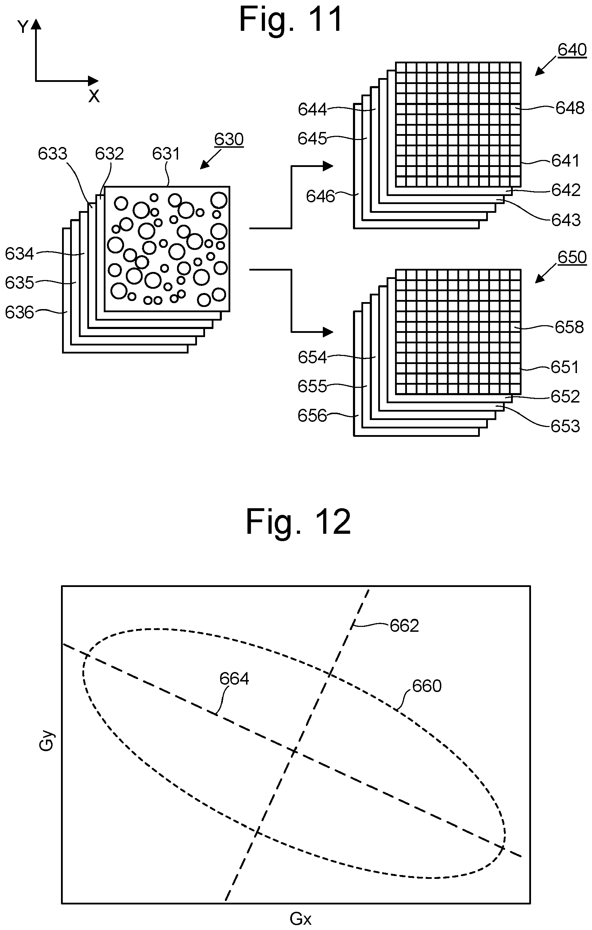

**FIG.** 11 depicts schematically how the information about directional sharpness can be obtained in sub-step S21 at multiple positions in each of the plurality of images. FIG. 11 (left) depicts an example plurality of images 630 for an exemplary case where the reference pattern comprises a plurality of circular features of different sizes. The plurality of images 630 in this example contains six individual images 631-636, schematically illustrated as a stack. Each of the images 631-636 is of the same reference pattern at a different focus condition (e.g., different Z position of the focal plane for the beam used to generate the image by scanning over the reference pattern on the sample 208).

In this example, two sets of values of directional sharpness are obtained for each image 631-636: a set of first values and a set of second values.

The set of first values is obtained for directional sharpness along a first direction (e.g., along an X direction) in each image 631-636. Each first value for an image 631-636 corresponds to a directional sharpness along the first direction at a different respective pixel 648 in a 12 × 12 grid of pixels representing respective positions in the image 631-636. The set of first values thus comprises 144 values of directional sharpness along the first direction for each image 631-636. In this example, there are six images 631-636 and therefore six 12 × 12 grids of first values, schematically illustrated as a stack 640 with six layers 641-646. In this example, the set of first values thus comprises 864 first values.

The set of second values is obtained for directional sharpness along a second direction (e.g., along a Y direction, perpendicular to the X direction) in each image 631-636. Each second value for an image 631-636 corresponds to a directional sharpness along the second direction at a different respective pixel 658 in a 12 × 12 grid of pixels representing respective positions in the image 631-636. The set of second values thus comprises 144 values of directional sharpness along the second direction for each image 631-636. In this example, there are six images 631-636 and therefore six 12 × 12 grids of second values, schematically illustrated as a stack 650 with six layers 651-656. In this example, the set of second values thus comprises 864 second values.

A value of directional sharpness in a particular direction will typically vary from pixel to pixel in an image due to variations in the reference pattern as a function of position. For example, portions of an image representing edges or interfaces of sharply defined features in the reference pattern may be expected to yield higher values of directional sharpness than portions of an image corresponding to a spatially uniform part of the reference pattern. Obtaining the information about directional sharpness at multiple positions provides more information about the astigmatism characteristic of the beam being used to obtain the image. For this reason is it desirable to obtain the information about directional sharpness at a relatively large number of positions in each image. 12 × 12 grids are shown in the example of **FIG. 11** but much larger grids may be used in practice. It is also possible to use smaller grids. The information about directional sharpness obtained at the multiple positions in each image 631-636 provides a distribution of directional sharpness data for each image 631-636. In the example of **FIG. 11****,** the distribution of directional sharpness data would comprise the 144 first values and the 144 second values corresponding to the image 631-636. For example, the distribution of directional sharpness data for image 631 in **FIG. 11** would comprise the 144 first values in layer 641 of stack 640 and the 144 second values in layer 651 of stack 650. The distribution of directional sharpness data for image 632 in **FIG. 11** would comprise the 144 first values in layer 642 of stack 640 and the 144 second values in layer 652 of stack 650 etc.

In an embodiment, the analyzing of the images of step S2 further comprises a sub-step S22 of using the directional sharpness data to estimate an orientation of axes of the astigmatism. The orientation of the axes may be estimated for example by analyzing correlations in the directional sharpness data between directional sharpnesses along different directions. Thus, in the example of **FIG. 11****,** sub-step S22 would comprise analyzing correlations between the first values and the second values to estimate the orientation of the axes of the astigmatism. For example, as depicted schematically in **FIG. 12****,** a scatterplot may be created with axes corresponding respectively to directional sharpness along different directions. In the example of **FIG. 12****,** the horizontal axis represents directional sharpness along the first direction, Gx, and the vertical axis represents directional sharpness along the second direction, Gy. A point is then plotted for each pixel in an image 631-636 for which a first value (i.e., a directional sharpness along the first direction) and a second value (i.e., a directional sharpness along the second direction) has been obtained. For the example of **FIG. 11****,** 144 points would be plotted on the scatterplot for a given image 631-636. Due to correlation between the first and second values the distribution of points defines an elongate region 660. The long axis 662 and the short axis 664 of the elongate region 660 correspond to the axes of astigmatism (e.g. a twofold astigmatism). A different scatterplot can be created and analyzed for each image 631-636. Scatterplots are useful for visualizing the analysis but do not need to be created in practice. They may serve as an aid as a pictorial representation. As exemplified below, for example, it is possible to analyze the directional sharpness data without creating scatterplots, for example using covariance matrices or other correlation functions, to obtain the orientation of the axes and the magnitudes of astigmatism.

In the examples described the astigmatism is two-fold and the two axes of the astigmatism are perpendicular to each other. It will be understood that for higher fold astigmatisms more than two axes of astigmatism may exist and the axes may be oriented differently than perpendicularly relative to each other. The number of axes may correspond to the number of folds of the astigmatism.

In an embodiment, the orientation of the axes of astigmatism are estimated by generating a covariance matrix representing the directional sharpness data and calculating one or more eigenvectors of the covariance matrix to estimate the orientation of the axes of the astigmatism. In the example of **FIG. 12****,** the eigenvectors of the covariance matrix would correspond to the directions of the long and short axes 662, 664 of the elongate region 660 and the eigenvalues would correspond to the relative sizes of the long and short axes 662, 664 of the elongate region 660. A separate covariance matrix can be generated for each image 631-636.

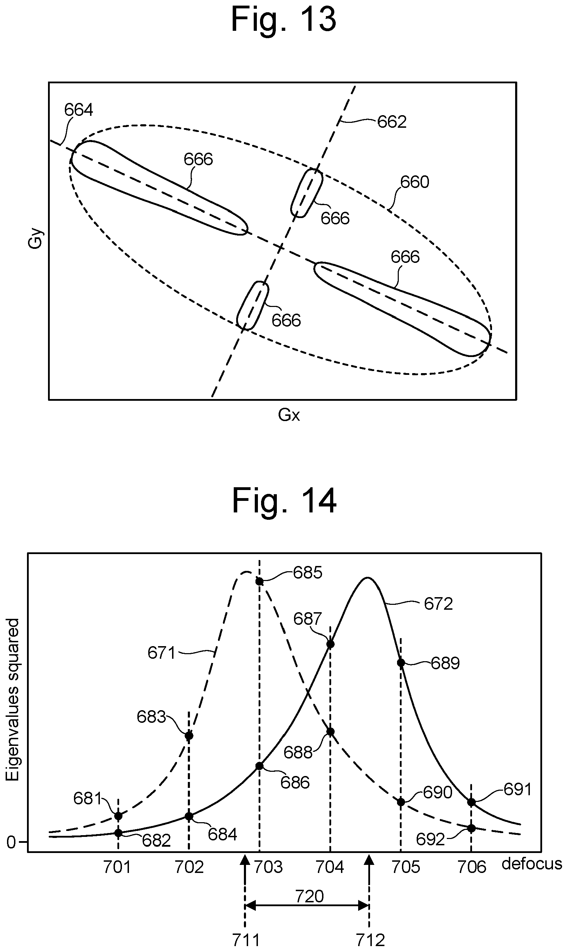

In an embodiment, as depicted in **FIG. 13****,** the analyzing of the images of step S2 further comprises a sub-step S23 comprising filtering the directional sharpness data. The filtering of the directional sharpness data may be performed prior to determining a magnitude of the astigmatism (described below). The filtering is configured to selectively remove a portion of the directional sharpness data. The filtering may be configured to remove directional sharpness data corresponding to directional sharpnesses that are maximum in a range of directions. The range of directions is a range of directions more than a threshold angle away from both of the axes of the astigmatism. The threshold angle may be about 20 degrees, optionally about 10 degrees, optionally about 8 degrees, optionally about 6 degrees, optionally about 4 degrees. The filtering may additionally or alternatively exclude directional sharpness data corresponding to a background level. For example, the filtering may be configured to remove directional sharpness data corresponding to directional sharpnesses that are below a threshold magnitude and/or that correspond to percentiles of directional sharpness below a threshold percentile (e.g., to pick only the percentiles that correspond to the sharpest data). **FIG. 13** schematically depicts sub-regions 666 within the larger elongate region 660 where directional sharpness data is partially or completely retained after the filtering. The filtering removes directional sharpness data that would otherwise bias the results of the analyses described below and thereby improves accuracy. Any of the subsequent sub-steps described below may use the filtered directional sharpness data or may use unfiltered directional sharpness data.

In an embodiment, the analyzing of the images of step S2 further comprises a sub-step S24 of using a variation in the directional sharpness data as a function of focus condition to determine a magnitude of the astigmatism. The magnitude of the astigmatism is determined quantitatively. Sub-step S24 may thus comprise outputting of a quantitative value representing the magnitude of the astigmatism. The determination of the magnitude of the astigmatism may, for example, comprise using the directional sharpness data to identify at least one focus condition at which a variance of the directional sharpness along a respective axis of the astigmatism is expected to be maximal. For example, where scatterplots (or at least the calculations from which the scatterplots are derived) are used for respective images corresponding to a plurality of focus conditions, the scatterplots (or at least the data which they represent) for which the elongate region 660 is more elongate could be identified as the focus condition at which the variance of the directional sharpness data along an axis of the astigmatism is expected to be maximal. Alternatively, a variation in the value of an eigenvalue of the covariance matrix as a function of focus condition could be analyzed to determine the focus condition at which the eigenvalue is maximum.

In an embodiment, sub-step S24 comprises using the directional sharpness data to identify a plurality of focus conditions at which variances of the directional sharpness along respective axes of the astigmatism are expected to be maximal. The identifying of each focus condition may comprise generating covariance matrices representing the directional sharpness data at respective different focus conditions and calculating a maximum as a function of focus condition of a respective eigenvalue of the covariance matrices. The magnitude of the astigmatism can be determined based on a magnitude of a difference between two of the identified focus conditions at which variances of the directional sharpness along respective axes of the astigmatism are expected to be maximal. FIG. 14 is a graph depicting an example application of sub-step S24. The horizontal axis represents a range of defocus (corresponding to a range of focus conditions) and the vertical axis represents the square of an eigenvalue. Curve 671 represents a variation as a function of defocus of a first eigenvalue (plotted as the square of the eigenvalue) of a covariance matrix. Curve 672 represents a variation as a function of defocus of a second eigenvalue (plotted as the square of the eigenvalue) of the covariance matrix. The curves 671 and 672 can be generated by plotting points corresponding to squares of eigenvalues obtained from images 631-636 and fitting curves to the plotted points. In the example shown, each image 631-636 is used to generate a covariance matrix corresponding to a value of defocus (the focus condition) at which the image 631-636 was obtained. Squares of the two eigenvalues calculated from the covariance matrix are then plotted on the graph at the respective value of defocus. In the example shown: points 681-682 are obtained from image 631 obtained at defocus 701; points 683-684 are obtained from image 632 obtained at defocus 702; points 685-686 are obtained from image 633 obtained at defocus 703; points 687-688 are obtained from image 634 obtained at defocus 704; points 689-690 are obtained from image 635 obtained at defocus 705; and points 691-692 are obtained from image 636 obtained at defocus 706. Any of various mathematical functions having a suitable form and/or number of degrees of freedom can be fitted to the plotted points. In an embodiment, a skewed Lorenzian is fitted to the plotted points. Calculating a maximum value of each fitted curve provides the focus condition at which the respective eigenvalue is maximal. The eigenvalue is maximal where a variance of the directional sharpness along an axis of astigmatism defined by the corresponding eigenvector is maximal. In the example shown, the focus conditions corresponding to the two maxima are respectively labelled 711 and 712.

In an embodiment, the magnitude of the astigmatism is determined in sub-step S24 based on a magnitude of a difference between two of the identified focus conditions at which variances of the directional sharpness along respective axes of the astigmatism are expected to be maximal. Thus, in the example of FIG. 14, the magnitude of astigmatism is determined based on the difference 720 between the focus condition at the maximum of curve 672 and the focus condition at the maximum of curve 671. For example, if the focus condition is varied by changing the position of a focal plane of a beam, the magnitude of the astigmatism would be equal to the difference in the position of the focal plane at the focus condition corresponding to the maximum 712 relative to the position of the focal plane at the focus condition corresponding to the maximum 711 (indicated by arrow 720 in **FIG. 14****).**

In an embodiment, the analyzing of the images of step S2 further comprises a sub-step S25 comprising determining a best focus of the beam. The best focus is determined quantitatively. Sub-step S25 may thus comprise outputting of a quantitative value representing the best focus. Sub-step S25 may output a setting of an apparatus that corresponds to the best focus, such that applying the setting to the apparatus achieves the best focus for the beam. The setting may define a focusing strength of a lens acting on the beam and/or a position and/or tilt of a sample support. The best focus may be obtained by performing a mathematical operation to obtain an intermediate value (which may be a middle point or middle value) between the identified focus conditions 711 and 712 at which variances of the directional sharpness along respective axes of the astigmatism are expected to be maximal. The best focus comprises the focus condition at which defocus is minimized. The mathematical operation may be an average (e.g., mean average) of the focus conditions 711 and 712. In the case where the focus condition is varied by changing the position of a focal plane of a beam, the determined best focus provides the position of the focal plane at which defocus is expected to be minimized.

The above-described method may be used to assess two or more (optionally all) beams of a beam grid comprising a plurality of beams. In such embodiments, each of the two or more beams of the beam grid may be scanned over a reference pattern corresponding to the beam by scanning the beam grid over the sample 208. The plurality of focus conditions in this case may comprise a plurality of beam grid focus conditions, such as a position of an average focal plane of the beam grid relative to the sample 208. Each of the two or more beams of the beam grid may be scanned over a reference pattern corresponding to the beam at each of the plurality of focus conditions by scanning the beam grid over the sample at each of a corresponding plurality of beam grid focus conditions. A plurality of images at the different focus conditions is thus generated for each of the two or more beams being assessed in parallel. This allows large numbers of beams to be assessed efficiently. The beam grid focus condition may be varied by changing a focusing power of an objective lens array and/or by changing a Z position and/or tilt of a sample support as described above. Varying the beam grid focus condition in such a manner may affect all beams of the beam grid at the same time in a coordinated manner. For example, the focusing power of the objective lens can be adjusted by varying a single potential applied to an electrode defining an array of apertures defining the objective lens array. The single potential affects the focal planes of all of the beams in a coordinated way.

Alternatively, in some implementations it may be possible to adjust the focal planes of different beams independently of each other, for example by one or more electrodes dedicated to individual beams. In this case, the beam grid focus condition could be defined by a set of individually selected focal plane positions for a corresponding set of beams of the beam grid. Various beam grid focus conditions are thus possible. Each beam grid focus condition should, however, affect at least the two or more beams of the beam grid that are being assessed. Each beam grid focus condition may define a position of a focal plane of a respective beam relative to a portion of a surface of the sample 208 defining a reference pattern corresponding to the beam. The reference patterns for different beams may be the same or different relative to each other. The method may be used to assess 10 or more, optionally 100 or more, optionally 1000 or more, optionally 10000 or more beams of a beam grid. Obtaining information about an astigmatism characteristic of individual beams in a multi-beam system is particularly challenging using alternative techniques, such as techniques that rely on iteratively adjusting a focus condition with a feedback loop until defocus or the effects of astigmatism are minimized. Such iterative techniques become rapidly unfeasible as the number of beams to be dealt with increases. The present approach allows best focus and astigmatism properties to be obtained individually for a large number beams of a beam grid with high speed and high precision. Macro-scale aberrations of the beam grid, such as field curvature across the beam grid, may thereby be characterized with high speed and high precision.

The method of assessing a charged particle beam described above has been exemplified predominantly in the context of assessment apparatuses configured to project a multi-beam (also referred to as a beam grid) of charged particles towards the sample 208. However, the skilled person would understand that, except where method steps specifically involve multiple beams of a multi-beam, the method is equally applicable to an assessment apparatus configured to project a single beam towards the sample 208 and/or may be applied to assessing a single beam of a beam grid.

The method of assessing a charged particle beam described above, particularly with reference **FIG. 8** to **14****,** may be used for assessing an electromagnetic beam having astigmatism if the electromagnetic beam is used instead of a charged particle beam for obtaining the images of the reference pattern at the plurality of focus conditions.

Reference to a component or system of components or elements being controllable to manipulate a charged particle beam in a certain manner includes configuring a controller or control system or control unit to control the component to manipulate the charged particle beam in the manner described, as well as optionally using other controllers or devices (e.g., voltage supplies and/or current supplies) to control the component to manipulate the charged particle beam in this manner. For example, a voltage supply may be electrically connected to one or more components to apply potentials to the components, such as in a non-limited list including the control lens array 250, the objective lens array 241, and the detector array 240.

References to upper and lower, up and down, above and below, etc. should be understood as referring to directions parallel to the (typically but not always vertical) up-beam and down-beam directions of charged particle beams impinging on the sample 208. Thus, references to up beam and down beam are intended to refer to directions in respect of the beam path independently of any present gravitational field. The references to beam path are to the intended position of a corresponding beam during operation of the charged particle apertures. Such references when made in reference to an electron-optical element, such as an electrode plate, may be generally understood to relate, for a collimated beam path, to the optical axis of the beam and thus the orthogonal to the plane of the electron-optical element. In reference to an uncollimated beam, such as a divergent beam, the beam path may be considered to be relative to the axis of the mid-point of the beam, or the mid-point of beam grid when the beam is a beam of a beam grid. Therefore, although the orientation of the beam path may be considered an axis orthogonal to the plane of a planar electron-optical element, this may not always be the case; in some embodiments the beam path is angled (e.g., obliquely) relative to such a planar electron-optical element.

Electron-optics described herein may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). Electron-optical elements may have magnetic elements and electrostatic elements. For example, a compound array lens may feature a macro magnetic lens encompassing the multi-beam path with an upper and lower pole plate within the magnetic lens and arranged along the multi-beam path. In the pole plates may be an array of apertures for the beam paths of the multi-beam. Electrodes may be present above, below or between the pole plates to control and optimize the electromagnetic field of the compound lens array.

An assessment apparatus, tool or system according to the disclosure may comprise apparatus which makes a qualitative assessment of a sample (e.g. pass/fail), one which makes a quantitative measurement (e.g. the size of a feature) of a sample or one which generates an image of map of a sample. Examples of assessment apparatus, tools or systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). It is appreciated that the invention may be applied to other types of apparatus such as a charged particle lithographic apparatus for use in generating patterns on a sample.

Functionality provided by the controller or control system or control unit may be computer-implemented. Any suitable combination of elements may be used to provide the required functionality, including for example CPUs, RAM, SSDs, motherboards, network connections, firmware, software, and/or other elements known in the art that allow the required computing operations to be performed. The required computing operations may be defined by one or more computer programs. The one or more computer programs may be provided in the form of media, optionally non-transitory media, storing computer readable instructions. When the computer readable instructions are read by the computer, the computer performs the required method steps. The computer may consist of a self-contained unit or a distributed computing system having plural different computers connected to each other via a network.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There is provided
Clause 1: A method of assessing a charged particle beam, comprising: generating a plurality of images of a reference pattern on a sample by scanning a charged particle beam over the reference pattern at each of a corresponding plurality of focus conditions and detecting signal charged particles emitted from the sample; and determining at least an astigmatism characteristic of the beam by analyzing the images.
Clause 2: The method of claim 1, wherein the plurality of focus conditions comprises a plurality of positions of a focal plane relative to a portion of a surface of the sample defining the reference pattern.
Clause 3: The method of claim 1 or 2, wherein the astigmatism characteristic comprises information about an N-fold astigmatism, where N is equal to or greater than 2.
Clause 4: The method of claim 3, wherein the analyzing of the images comprises determining information about directional sharpness along multiple directions in each image.
Clause 5: The method of claim 4, wherein the determining the information about directional sharpness comprises determining gradients of an image parameter along the multiple directions, the image parameter optionally comprising an image intensity.
Clause 6: The method of claim 4 or 5, wherein the information about directional sharpness is obtained at multiple positions in each image, thereby providing a distribution of directional sharpness data for each image.
Clause 7: The method of claim 6, comprising using the directional sharpness data to estimate an orientation of axes of the astigmatism.
Clause 8: The method of claim 7, wherein the orientation of the axes are estimated by analyzing correlations in the directional sharpness data between directional sharpnesses along different directions.
Clause 9: The method of claim 8, comprising generating a covariance matrix representing the directional sharpness data and calculating one or more eigenvectors of the covariance matrix to estimate the orientation of the axes of the astigmatism.
Clause 10: The method of any of claims 6 to 9, comprising using a variation of the directional sharpness data as a function of the focus condition to determine a magnitude of the astigmatism.
Clause 11: The method of claim 10, wherein the determination of the magnitude of the astigmatism comprises using the directional sharpness data to identify at least one focus condition at which a variance of the directional sharpness along a respective axis of the astigmatism is expected to be maximal.
Clause 12: The method of claim 10 or 11, wherein the determination of the magnitude of the astigmatism comprises using the directional sharpness data to identify a plurality of focus conditions at which variances of the directional sharpness along respective axes of the astigmatism are expected to be maximal.
Clause 13: The method of claim 12, wherein the magnitude of the astigmatism is determined based on a magnitude of a difference between two of the identified focus conditions at which variances of the directional sharpness along respective axes of the astigmatism are expected to be maximal.
Clause 14: The method of claim 12 or 13, wherein a best focus of the beam is determined by performing a mathematical operation to obtain an intermediate value between the identified focus conditions, optionally the mathematical operation being an average of the identified focus conditions.
Clause 15: The method of any of claims 11 to 14, wherein the identifying of each focus condition comprises generating covariance matrices representing the directional sharpness data at respective different focus conditions and calculating a maximum as a function of focus condition of a respective eigenvalue of the covariance matrices.
Clause 16: The method of any of claims 11 to 15, comprising filtering the directional sharpness data prior to determining the magnitude of the astigmatism to: remove directional sharpness data corresponding to directional sharpnesses that are maximum in a range of directions more than a threshold angle away from both of the axes of the astigmatism; and/or to remove directional sharpness data corresponding to directional sharpnesses that are below a threshold magnitude and/or that correspond to percentiles of directional sharpness below a threshold percentile.
Clause 17: The method of any preceding claim, wherein the reference pattern comprises at least one shape having a boundary that is at least partially curved, optionally circular, elliptical or oval, optionally wherein the reference pattern comprises a plurality of circular features of different sizes.
Clause 18: A method of assessing a beam grid comprising a plurality of charged particle beams, comprising using the method of any preceding claim to assess two or more beams of the beam grid.
Clause 19: The method of claim 18, wherein each of the two or more beams of the beam grid is scanned over a reference pattern corresponding to the beam by scanning the beam grid over the sample.
Clause 20: The method of claim 18 or 19, wherein each of the two or more beams of the beam grid is scanned over a reference pattern corresponding to the beam at each of the plurality of focus conditions by scanning the beam grid over the sample at each of a corresponding plurality of beam grid focus conditions.
Clause 21: The method of claim 20, wherein each beam grid focus condition affects at least the two or more beams of the beam grid that are being assessed, each beam grid focus condition optionally defining a position of a focal plane of a respective beam relative to a portion of a surface of the sample defining a reference pattern corresponding to the beam.
Clause 22: The method of any preceding claim, wherein the determining at least an astigmatism characteristic comprises quantitatively determining the astigmatism characteristic, desirably the quantitatively determining the astigmatic characteristic comprises determining a magnitude of the astigmatism characteristic.
Clause 23: A method of quantitatively determining an astigmatism of a charged particle beam, comprising generating a plurality of images of a reference pattern on a sample by scanning a charged particle beam over the reference pattern at each of a corresponding plurality of focus conditions and detecting signal charged particles emitted from the sample; and quantitatively determining at least an astigmatism characteristic of the beam by analyzing the images.
Clause 24: The method of claim 23, wherein the quantitatively determining at least the astigmatism characteristic comprises determining a magnitude of the astigmatism characteristic.
Clause 25: An assessment apparatus, comprising: a charged particle-optical system configured to project a charged particle beam towards a sample comprising a reference pattern; a detector configured to detect signal charged particles emitted from the sample; and a controller configured to: a. control at least the charged particle-optical system to scan the charged particle beam over the reference pattern of the sample at a plurality of focus conditions; b. receive a detection signal from the detector, the detection signal representing signal charged particles emitted from the sample at the different focus conditions; c. generate from the detection signal a plurality of images of the reference pattern corresponding to the plurality of focus conditions; and d. determining at least an astigmatism characteristic of the beam by analyzing the images.
Clause 26: An assessment apparatus, comprising: a charged particle-optical system configured to project a beam grid comprising a plurality of charged particle beams towards a sample having reference patterns; a detector configured to detect signal charged particles emitted from the sample; and a controller configured to: a. control at least the charged particle-optical system to scan each of two or more beams of the beam grid over a reference pattern of the sample corresponding to the beam at a plurality of focus conditions; b. receive a detection signal from the detector, the detection signal representing signal charged particles emitted from the sample at the different focus conditions; c. generate from the detection signal a plurality of images of the reference pattern corresponding to the plurality of focus conditions for each of the two or more beams; and d. determining at least an astigmatism characteristic of the beam by analyzing the images.
Clause 27: The apparatus of claim 25 or 26, wherein the charged particle-optical system comprises the detector.
Clause 28: The apparatus of any of claims 25 to 27, wherein the apparatus comprises a sample support and the controller is configured to provide the plurality of focus conditions at least partly by controlling the sample support to vary a position and/or tilt of the sample.
Clause 29: The apparatus of any of claims 25 to 28, wherein the controller is configured to provide the plurality of focus conditions at least partly by varying a focus setting of the charged particle-optical system, desirably to vary a position of a focal plane of the charged particle beam relative to the charged particle-optical system.

## Claims

1. A method of assessing a charged particle beam, comprising:
generating a plurality of images of a reference pattern on a sample by scanning a charged particle beam over the reference pattern at each of a corresponding plurality of focus conditions and detecting signal charged particles emitted from the sample; and
determining at least an astigmatism characteristic of the beam by analyzing the images.

2. The method of claim 1, wherein the plurality of focus conditions comprises a plurality of positions of a focal plane relative to a portion of a surface of the sample defining the reference pattern.

3. The method of claim 1 or 2, wherein the astigmatism characteristic comprises information about an N-fold astigmatism, where N is equal to or greater than 2.

4. The method of claim 3, wherein the analyzing of the images comprises determining information about directional sharpness along multiple directions in each image.

5. The method of claim 4, wherein the determining the information about directional sharpness comprises determining gradients of an image parameter along the multiple directions, the image parameter optionally comprising an image intensity.

6. The method of claim 4 or 5, wherein the information about directional sharpness is obtained at multiple positions in each image, thereby providing a distribution of directional sharpness data for each image.

7. The method of claim 6, comprising using the directional sharpness data to estimate an orientation of axes of the astigmatism.

8. The method of claim 7, wherein the orientation of the axes are estimated by analyzing correlations in the directional sharpness data between directional sharpnesses along different directions.

9. The method of claim 8, comprising generating a covariance matrix representing the directional sharpness data and calculating one or more eigenvectors of the covariance matrix to estimate the orientation of the axes of the astigmatism.

10. The method of any of claims 6 to 9, comprising using a variation of the directional sharpness data as a function of the focus condition to determine a magnitude of the astigmatism.

11. The method of claim 10, wherein the determination of the magnitude of the astigmatism comprises using the directional sharpness data to identify at least one focus condition at which a variance of the directional sharpness along a respective axis of the astigmatism is expected to be maximal.

12. The method of claim 10 or 11, wherein the determination of the magnitude of the astigmatism comprises using the directional sharpness data to identify a plurality of focus conditions at which variances of the directional sharpness along respective axes of the astigmatism are expected to be maximal.

13. The method of claims 11 or 12, comprising filtering the directional sharpness data prior to determining the magnitude of the astigmatism to:
remove directional sharpness data corresponding to directional sharpnesses that are maximum in a range of directions more than a threshold angle away from both of the axes of the astigmatism; and/or
to remove directional sharpness data corresponding to directional sharpnesses that are below a threshold magnitude and/or that correspond to percentiles of directional sharpness below a threshold percentile.

14. A method of assessing a beam grid comprising a plurality of charged particle beams, comprising using the method of any preceding claim to assess two or more beams of the beam grid.

15. The method of any preceding claim, wherein the determining at least an astigmatism characteristic comprises quantitatively determining the astigmatism characteristic, desirably the quantitatively determining the astigmatic characteristic comprises determining a magnitude of the astigmatism characteristic.
